Europäisches Patentamt

European Patent Office

Office européen des brevets

(19)

(11) Publication number: **0 017 412**
**B1**

(12) **EUROPEAN PATENT SPECIFICATION**

(45) Date of publication of patent specification: 05.05.82

(51) Int. Cl.³: **H 05 K 7/14, H 01 R 23/70**

(21) Application number: **80300912.5**

(22) Date of filing: **24.03.80**

(54) A circuit card interconnection assembly.

(30) Priority: **04.04.79 US 27130**

(43) Date of publication of application:
**15.10.80 Bulletin 80/21**

(45) Publication of the grant of the patent:
**05.05.82 Bulletin 82/18**

(84) Designated Contracting States:
**BE CH DE FR GB IT NL SE**

(56) References cited:
**DE - A1 - 2 545 505**
**DE - A1 - 2 757 811**
**DE - B2 - 2 419 915**
**US - A - 3 704 394**
**US - A - 3 725 843**

(73) Proprietor: **AMP INCORPORATED**
**Eisenhower Boulevard**
**Harrisburg, Pennsylvania (US)**

(72) Inventor: **Cobaugh, Robert Franklin**
**Box 144A, R.D. No.2**
**Elizabethtown Pennsylvania 17022 (US)**
Inventor: **Taylor, Attalee Snarr**
**Box 430E, R.D. No.1**
**Palmyra Pennsylvania 17078 (US)**

(74) Representative: **Terrell, Thomas Gwyn et al,**
**20 Queensmere**
**Slough, Berkshire SL1 1YZ (GB)**

Courier Press, Leamington Spa, England.

## A circuit card interconnection assembly

There is described in United States Patent Specification No. 3,147,404, a circuit card interconnection assembly, comprising a base circuit board, a plurality of card edge electrical connectors mounted on the base circuit board and each defining a card receiving channel containing card engaging contact elements connected to conductors of the base circuit board, the base circuit board being provided with power and ground return bus conductors connected to the circuits of circuit cards received in the card receiving channels of the card edge connectors.

In this known assembly the bus conductors are in the form of flat metal plates on opposite surfaces of the base circuit board and being connected to the circuit of the circuit cards through contacts elements of the card edge connectors themselves by way of post portions of these contact elements, which have been bent over to extend between the housings of the card edge connectors and the base circuit board.

The present invention relates in particular to a circuit card interconnection system for a complex high speed digital logic system, employing double sided multi-layer circuit cards carrying semi conductor chips.

As the number of circuit cards to be supplied by the bus conductors and the density of circuit components on each card, is increased, the amount of current drawn from each bus conductor increases accordingly. For example, in a typical complex interconnection assembly, the circuit cards draw a cumulative total of 200 amps or more from each bus conductor, so that each bus conductor must have a cross section which is in excess of 33 mm2 to provide adequate current carrying capacity. This requirement for size obviates the use of a bus conductor which is stamped and formed from relatively thin metal plate and also precludes incorporation of the bus conductors into the card edge connectors according to the teaching of United States Patent Specification No. 3,704,394 or 3,725,843, since the sizes of, and the spacing between, the contact elements of the card edge connector are too small (of the order of 2.45 mm to 1.588 mm) to permit of this.

The heavy current carried by the bus conductors of such a system, as well as voltage losses and inductance effects produced by the bus conductors tends adversely to affect the low signal voltages carried by the card edge connector contact elements. Therefore, each bus conductor should be isolated from, rather than incorporated into, the card edge connectors.

In an interconnection assembly, a multiplicity of circuit card connections to the circuit cards, when such connections are distributed along a bus conductor, will cause a cumulative power drain and voltage drop. If a bus conductor is indirectly connected to the associated circuit cards, additional voltage drops occur as a result of contact resistances and the bulk resistances of the indirect connections. The connections to the bus conductors should therefore be such as to avoid cumulative power drain and to minimize voltage drops resulting from additional resistance effects. Additional voltage losses are attributable to inductance effects. Voltage inductance losses are directly proportional to the rate of change of signal and the inductances of the bus conductor and the connection. between the bus conductor and its circuit cards. The rise times of the digital signals which are operative in each circuit card are measured in nanoseconds or fractions of nanoseconds. These short rise times will produce significant millivolt inductance drops, so that the bus conductor connections must be designed for minimum millivolt reactance losses.

According to the present invention, a circuit card interconnection assembly as defined in the first paragraph of this specification is characterised in that the bus conductors are in the form of spaced metal bus bars secured against the base circuit board and extending from end to end thereof, the card edge connectors being positioned between the ground return bars, there being distributed axially along the bars and thereover, ground return and power electrical connector module housings each having a card receiving slot aligned with the card receiving slot of an adjacent circuit card edge connector and receiving a portion of a card which is also received in the card receiving channel of the adjacent card edge connector, each electrical connector module housing containing electrical terminals each frictionally engaging a conductor on such portion, and each being electrically and mechanically directly connected to an appropriate one of the bars by means of a post portion of the terminal, which has been force fitted into an opening in the bar.

It is believed that the undesired power losses mentioned above, which are the sum of the resistive, inductance and capacitance losses, are mitigated, because the bus bars, which as a result of their physical arrangement, can be of the required large cross-section, are physically separated from the card edge connectors and from the circuits of the cards, resistive losses and stray inductance and capacitance effects being minimized by the direct connections between the terminals of the connector module housings and the bus bars. Capacitance losses can be reduced to a minimum by properly spacing adjacent bus bars. Since the connections between the bus bars and the cards are made through the terminals of the connector module housings, which terminals are of much smaller number than those of the card edge connectors, the power losses may also be reduced, whilst yet having due regard to economy of manufacture and to the space available, by making the terminals of the connector module housings of appropriately thick metal stock and of appropriately short length. The physical sizes of the bars and of the terminals are not limited by the confines of the said card edge connectors. The force fit connections between the terminals and the bus bars facilitate easy and rapid construction of the assembly and may indeed constitute the sole means for retaining the module housings in the assembly.

Reference will now be made by way of example to the accompanying drawings, in which:—

Figure 1 is a perspective view, with part broken away, of a circuit card interconnection assembly for a complex high speed digital logic system;

Figure 2 is a fragmentary, exploded, perspective view of the assembly;

Figure 3 is a perspective view showing the parts shown in Figure 2 in their assembled condition;

Figure 4 is an enlarged exploded elevational view, shown partly in section, of some of the parts shown in Figures 2 and 3;

Figure 5 is a view taken on the lines V—V of Figure 6, the circuit card shown in Figure 6, not being shown;

Figure 6 is a sectional view of a ground return connector module of the assembly, receiving a circuit card;

Figure 7 is a view of a power bus bar connector module of the assembly, taken on the lines VII—VII of Figure 8; and

Figure 8 is a view taken on the lines VIII—VIII of Figure 7.

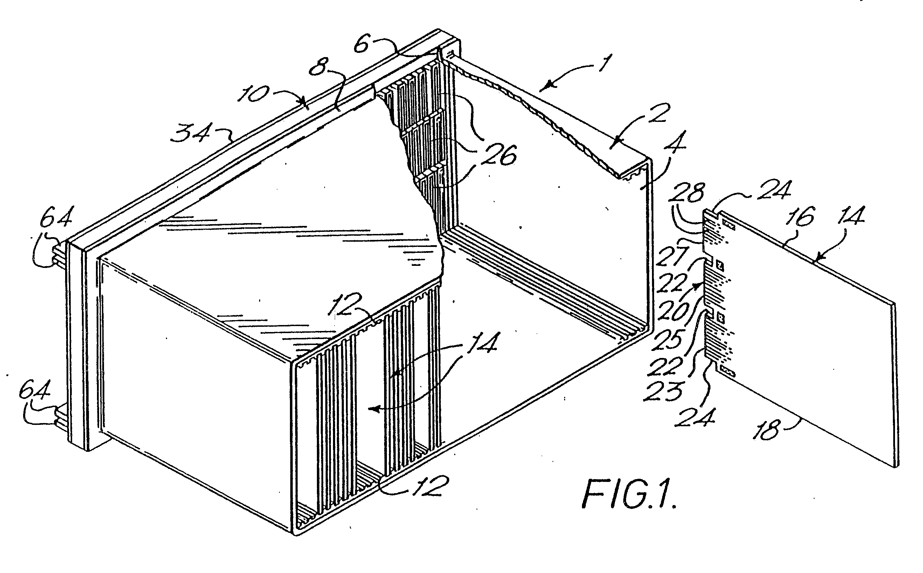

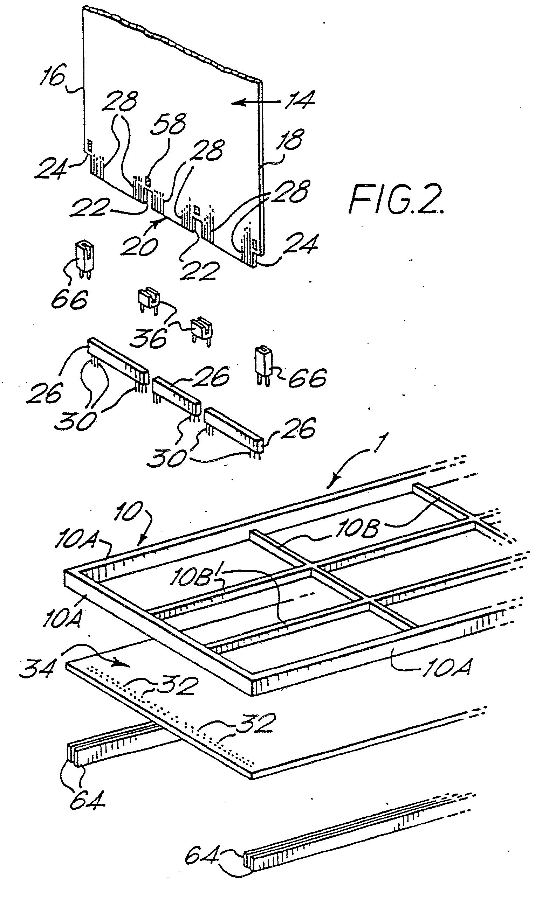

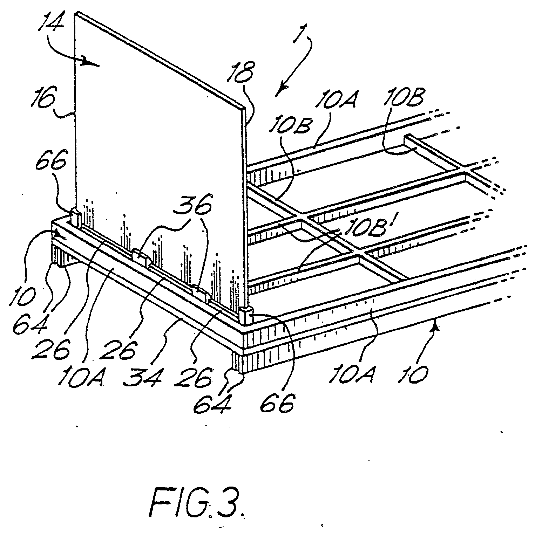

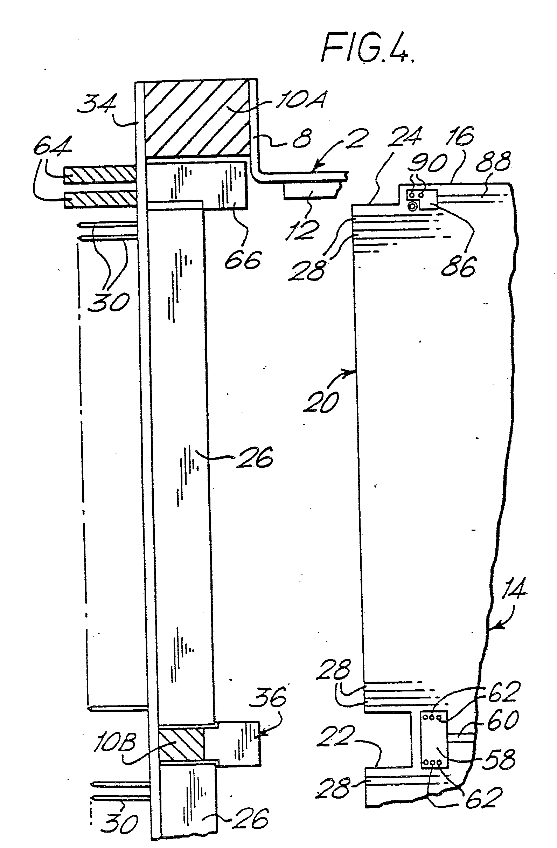

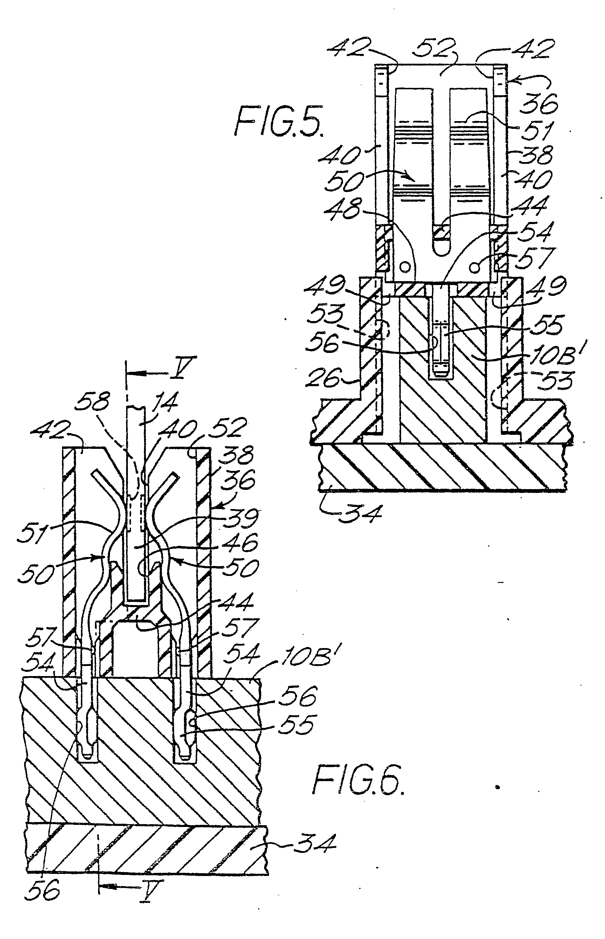

As shown in Figure 1, a circuit card interconnection assembly 1, comprises a chassis in the form of a rectangular metal box 2 having opposite open ends 4 and 6, respectively, the end 6 being encircled by a lip flange 8 secured by fasteners (not shown) to an electrically conductive framework 10 constituting a ground return bus bar assembly and which may be made for example of copper or aluminium. As shown in Figures 2 and 3 the framework 10, comprises outer bars 10A bridged by transverse inner bars 10B which are in turn bridged by longitudinal inner bars 10B', so that the framework 10 has the form of a grid, all the bars being solid.

The top and bottom (as seen in Figure 1) sides of the box 2 are provided with parallel, circuit card guide grooves 12 for removably receiving double sided, rectangular, multi-layer circuit cards 14 inserted through the end 4 of the box 2 which end is open, so that their top and bottom (as seen in Figure 1) edges 16 and 18 are slidably guided and supported in the grooves 12. The leading edge 20 of each card 14 is formed with a series of rectangular notches 22 and 24 which divide the edge 20 into three coplanar segments 23, 25 and 27, respectively, which are elongate in a direction perpendicular to the edges 16 and 18, and which are plugably received in respective conventional card edge electrical connectors 26 each comprising an insulating housing defining a card receiving channel opening inwardly of the box 2 and in which there are two rows of electrical spring contact elements (not shown) for engaging both sides of the respective segment 23, 25 or 27.

Connecting posts 30 of the said contact elements depend from the housings of the connectors 26 as shown in Figure 2, for reception in apertures 32 in a planar base circuit board 34 so that the cards, when inserted into the connectors 26, project therefrom at right angles to the plane of the board 34 in parallel aligned relationship supported in the grooves 12, as shown in Figure 1.

The circuits of the cards 14 are electrically interconnected through electrical conductors (not shown) on the board 34 which are in electrical contact with the posts 30 in the apertures 32, through metal plating (not shown) therein. The posts 30 may project from the underside of the board 34 for connection to external circuits (not shown) by way of leads (not shown) connected to posts 30 e.g. by wire wrapping.

The interconnections described above, between the circuits of the cards 14 transmit low voltage digital signals, at high speed to and from electronic components (not shown), e.g. semi conductor chips, of the circuits on both sides of the cards 14. The voltages of these signals which are typically one or five volt signals, should remain constant when the circuits are in operation, if the electronic components are to be correctly operated, voltage losses even of the order of millivolts being generally unacceptable.

As seen in Figures 2 and 3, the framework 10 is assembled to the upper side of board 34, being secured thereto e.g. by means of screws (not shown), the framework 10 serving to stiffen and support the board 34 against deflection as a result of a card 14 being forcefully inserted into the corresponding connectors 26 which are disposed in the spaces defined between the bars of the framework 10, the notches 22 in the cards 24 providing clearance for the bars 10B'.

The cards 14 can be removed from the box 2, and the board 34 with the connectors 26 thereon can be removed from the framework 10 and the box 2; for repair or modification of the circuits.

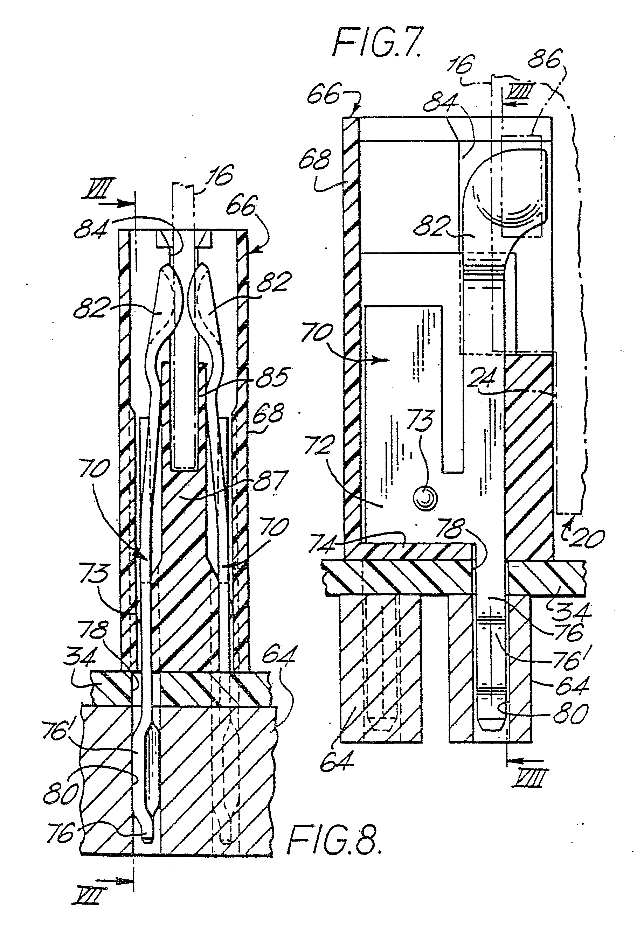

Each card 14 is directly connected to a bar 10B' of the framework 10 by means of ground return connector modules 36 (shown in detail in Figures 5 and 6) which fit into the notches 22 of the card 14 as will best be apparent from the lower part of Figure 4, when the card 14 has been plugged into the corresponding connectors 26.

As shown in Figures 5 and 6, each module 36 comprises an open topped insulating housing 38 having central slots 40 provided in opposed side walls 42 of the housing 38 for receiving a portion 39 of a card 14 at the base of one of the notches 22 thereof. An internal web 44 in the housing 38, spanning the walls 42, is formed with a recess 46 in alignment with the slots 40, to receive and support the leading margin of the card portion 39, the web 44 being formed integrally with a bottom wall 48 of the housing 38, which wall engages the bar 10B' therebeneath. The slots 40 and the recess 46 open inwardly of the box 2.

On each side of the web 44 and the slots 40, there is provided in the housing 38, an electrical terminal 50 having a spring contact portion 51 in the form of stiffly resilient metal strip. In assembling the module 36, the terminals 50 are inserted into the housing 38 through its open top 52 so that a longitudinally slotted, bifurcated section 55 of a post 54 depending from the contact portion 51 of the terminal 50 is force fitted into a recess 56 drilled in the bar 10B', to provide secure, direct, mechanical and electrical connection between the terminal 50 and the bar 10B', bosses 57 on the terminals 50 serving to wedge them in the housing 38. Such mechanical connection, which is obtained by virtue of the resilience of the section 55 in the transverse direction of the post 54, is the sole means provided for retaining the module 36 in position in the assembly. The said mechanical connection may be made as massive as may be required to carry adequate current with minimum power loss.

As shown in Figure 6, the contact portion 51 of each terminal 50 frictionally engages one side of a card 14, bearing against an electrically conductive, plated ground return pad 58 on the card 14. The contact portion 51 of each terminal 50 and the corresponding pad 58 may be made as large as necessary in contact area to carry adequate current between the card 14 and the bar 10B'.

Each pad 58 is electrically connected directly to a ground return circuit path 60 (Figure 4) on card 14. Also, internally plated, through holes 62 in the card 14 have their internal plating directly electrically connected to the pads 58 and to ground circuit paths on internal laminates (not shown) of the card 14. As shown in Figure 5, each housing 38 is open along the intersection of each of its side walls 42 with the bottom wall 48 to allow for the passage of fan-forced cooling air over the terminals 50. The walls 42 are connected to the wall 48 by webs 49 each of which fits slidably into a groove 53 in one end of the housing of an adjacent one of the card edge connectors 26 so that the module 36 is precisely positioned and stabilized in alignment with the two adjacent connectors 26.

As shown in Figures 1 to 4, pairs of power bus bars 64 made for example of copper of high electrical conductivity, are supported against the opposite side of the board 34 to that on which the framework 10 is mounted, the bars 64 serving to prevent distortion of the board 34, in co-operation with the framework 10. One bar 64 of each pair may for example be used to supply a five volt power input to each card 14, the other bar 64 being used to supply current at one volt to each card 14. The bars 64 of each pair are separated by an air gap or by solid insulating material, for the control of cross-capacitance between the bars 64 of the pair.

Power bus bar modules 66 are mounted on the board 34, outwardly of the connectors 26, for connecting the circuits of the cards 14 to the bars 64. As shown in Figures 7 and 8, each module 66 comprises an open topped, moulded insulating housing 68 containing a pair of terminals 70 formed from thick and stiffly resilient metal stock, similarly to that of the terminals 50. Each terminal 70 comprises a planar base portion 72 (Figure 7) an edge of which engages a planar bottom wall 74 of the housing 68, a post 76 projecting from the portion 72, freely through an aperture 78 in the board 34.

The post 76 which is bifurcated, at 76', in a similar way to the posts 54 and to a similar end, is force fitted into an opening 80 drilled in the corresponding bus bar 64, which is disposed on the opposite side of the board 34 to the module 66, electrically and mechanically to connect the terminal 70 securely and directly to the bar 64. In assembling a module 66, the terminals 70 are inserted into the housing 68 through its own top, bosses 73 on the portions 72 of the terminals 70 causing them to be wedged in the housing 68. The mechanical connections between the posts 76 and the bars 64 are the sole means provided for supporting and securing the modules 66 and the bars 64 to the base circuit board 34, and may be made as massive as may be necessary to carry adequate current with minimum loss of power.

Each terminal 70 also comprises an elongate cantilever spring contact blade 82 in alignment with slots 84 formed in opposite side walls of the housing 68 and a recess 85 formed in a central web 87 of the housing 68, the slots 84 and recesses 85 serving to receive a card 14, to an extent limited by their depth. The slots 84 and the recess 85 open inwardly of the housing 2.

As will be apparent from Figures 4, 7 and 8, each module 66 is received in one of the end notches 24 of an inserted card 14, a lateral margin of the card adjacent to its edge 16 being received in the slots 84 and between the blades 82 each of which frictionally engages a metal pad 86 on a respective side of the card 14. Each blade 82 and the corresponding pad 86 may be made as large in contact surface area as may be necessary to carry adequate current between the card 14 and the bar 64.

As shown at the upper part of Figure 4, each pad 86 is electrically connected directly to a plated power circuit path 88 on the inserted card 14. The pad 86 is also connected to the plating of internally plated holes 90 in the card 14, such plating being directly electrically connected to circuit paths of internal laminations (not shown) of the card 14. Each bar 64 is thereby electrically connected to the power circuitry mentioned above, through the terminals 70 and pads 86.

As mentioned above, the low voltage digital signals which are transmitted between the electronic circuit components on the cards 14 should remain constant within very close tolerances, so that despite the multiplicity of the cards 14 and the multiplicity of the components that are provided on each card 14, voltage losses in the ground return system resulting from contact resistances and from the resistance of the ground return bus bar network itself must be held to an absolute minimum. The bus bar network constituted by the framework 10 is accordingly of sufficiently massive construction to be of very low ohmic resistance, the thickness of the terminals 50 and their direct force fit connections to the bars 10B' also serving to minimize voltage drop.

Since the rise times of the digital signals are of the order of nanoseconds or indeed of the order of fractions thereof, the incidence of millivolt reaction losses must also be minimized, since such losses are directly proportional to the rates of signal change involved. The framework 10 and its means of connection to the conductors of the cards 14 are such as to minimize the incidence of stray inductances and capacitances in the ground return system, commensurately to minimize the reactance losses mentioned above. The framework 10 is electrically isolated, apart from being connected thereto by way of the terminals 50, from the digital signal circuits of the cards 14 in such a way that cross-talk between the framework 10, which carries substantial current, and such circuits is avoided. To this end each bar 10B' is engaged by the lower (as seen in Figures 5 and 6) faces of the housings 38 rather than being incorporated thereinto, so that the inserted cards 14 are effectively physically spaced from the framework 10.

The terminals 70 are such as to provide short, direct, low ohmic resistance paths between the pads 86 and the power bus bars 64, the force fit relationship between the posts 76 and the bars 64 also serving to minimize the ohmic resistance of such paths, as mentioned above.

The inductance of each terminal 70 is minimized by virtue of the short length of the terminal 70 relative to its cross-sectional area, commensurately to minimize inductance losses in respect of the high speed signals conducted by the terminal 70 from its bus bar 64.

The bus bars 64 are effectively isolated from the signal circuits of the cards 14 by virtue of the very substantial spacing between the bars 64 and the cards 14, as will be apparent from Figures 7 and 8, the bars 64 being positioned on the opposite side of the board 34 to the cards 14 the movement of which towards the board 34 is limited by the depth of the slots 40 and recesses 46.

The cards 14 are also spaced from the board 34 by virtue of the limited depth of the slots 84 and recesses 85.

Framework 10 and the bars 64, which extend the full length of the base circuit board 34, i.e. from end to end thereof, co-operate to reinforce the board 34 against any warping.

## Claims

1. A circuit card interconnection assembly (1), comprising a base circuit board (34), a plurality of card edge electrical connectors (26) mounted on the base circuit board (34) and each defining a card (14) receiving channel containing card engaging contact elements connected to conductors of the base circuit board (34), the base circuit board (34) being provided with power (64) and ground return (10) bus conductors extending therealong and being connected to the circuits of circuit cards (14) received in the card receiving channels of the card edge connectors (26); characterised in that the bus conductors are in the form of spaced metal bus bars (64 and 10A, 10B') secured against the base circuit board (34) and extending from end to end thereof, the card edge connectors (26) being positioned between the ground return bars (10A and 10B'), there being distributed axially along the bars (64 and 10B') and thereover, ground return and power electrical connector module housings (38 and 68) each having a card receiving slot (40, 84) aligned with the card receiving slot of an adjacent circuit card edge connector (26), and receiving a portion of a card (14) which is also received in the card receiving channel of the adjacent card edge connector (26), each electrical connector module housing (38 or 68) containing electrical terminals (50 or 70) each frictionally engaging a conductor (58 or 86) on such portion, and each being electrically and mechanically directly connected to an appropriate one of the bars (10B' and 64) by means of a post portion (54 or 76) of the terminal, which has been force fitted into an opening (56 or 80) in the bar (10B' or 64).

2. An assembly according to Claim 1, characterised in that the ground return bus conductors (10B') are comprised in a framework (10) of bars (10A, 10B, 10B') secured against one surface of the base circuit board (34), the power bus conductors (64) being secured to the opposite surface of the base circuit board (34), appropriate terminals (70) of the electrical connector module housings (68) extending through the base circuit board (34) into the power bus conductors (64).

3. An assembly according to Claim 2, characterised in that the framework (10) is in the form of a grid, outer bars (10A) of which are secured to an open end of a chassis in the form of a metal box (2), the card receiving channels of the card edge connectors (26) and the card receiving slots (40 and 84) of the electrical connector housings (38 and 68) opening inwardly. of the chassis (2) which is provided with internal grooves for guiding the cards (14) into the channels of the card edge connectors (26) and into the slots (40 and 84) of the electrical connector module housings (38 and 68).

4. An assembly according to Claim 2 or 3, characterised in that the power bus conductors comprise pairs of parallel spaced bars (64) extending along opposite outer margins of the framework (10).

5. An assembly according to any one of the preceding claims, characterised in that each connector module housing (38 or 68) comprises an insulating member (44 or 85) which is engageable by an edge of a card (14) inserted into the card receiving slot (40 or 84) of the housing (38 or 68), to retain the edge of the card (14) in a position remote from the associated bar (10B' or 64).

6. An assembly according to any one of the preceding claims, characterised in that the post portions (54 and 76) of the terminals have sections (55 or 76') which are longitudinally slotted so as to be resilient in the transverse direction of the post portions (54 and 76), the longitudinally slotted sections (55 or 76') of the post portions (54 or 76) resiliently engaging the walls of the openings (56 and 80) which have been drilled in the bars (10B' or 64).

7. An assembly according to any one of the preceding claims, characterised in that each electrical connector module housing (38 or 68) is received in a notch (22 or 24) in the card (14) received in the slot (40 or 84) of the housing (38 or 68), each terminal (50 or 70) of the module housing (38 or 68) having a spring contact portion (51 or 82) engaging a metal pad (58 or 86) on the card (14) at the base of the notch (22 or 24), each pad (58 or 86) being connected by way of internally plated holes (62 or 90) in the card (14) to an internal circuit path of the card (14) and being directly connected to a surface conductor (60 or 88) of the card (14).

8. An assembly according to any one of the preceding claims, characterised in that the electrical connector module housings (38), the terminals (50) of which are connected to the ground return bus conductors (10B') have opposite side walls (42) each having a web (49) fitted into a groove (53) in an end wall of an adjacent circuit card edge connector (26), the electrical connector housings (68) the terminals (70) of which are connected to the power bus conductors, being disposed adjacent to lateral edges of the base circuit board (34) and thus outwardly of the circuit card edge connectors (26).

## Revendications

1. Ensemble (1) d'interconnexion de cartes à circuits, comprenant une plaquette (34) à circuit de base, plusieurs connecteurs électriques (26) de bords de cartes montés sur la plaquette (34) à circuit de base et présentant chacun une rainure de réception d'une carte (14) contenant des éléments de contact engageant une carte et connectés à des conducteurs de la plaquette (34) à circuit de base, la plaquette (34) à circuit de base portant des conducteurs communs d'alimentation (64) et de retour à la masse (10) s'étendant le long de cette plaquette et connectés aux circuits des cartes (14) à circuits logées dans les rainures de réception de cartes des connecteurs (26) de bords de cartes, caractérisé en ce que les conducteurs communs se présentent sous la forme de barres omnibus métalliques et espacées (64 et 10A, 10B') fixées contre la plaquette (34) à circuit de base et s'étendant de l'une à l'autre de ses extrémités, les connecteurs (26) de bords de cartes étant positionnés entre les barres (10A et 10B') de retour à la masse, des boîtiers (38 et 68) de modules de connecteurs électriques de retour à la masse et d'alimentation étant distribués axialement le long des barres (64 et 10B') et au-dessus d'elles, et présentant chacun une fente (40, 84) de réception d'une carte, alignée avec la fente de réception de carte d'un connecteur adjacent (26) de bord de carte à circuit, et recevant une partie d'une carte (14) qui est également reçue dans la rainure de réception de carte du connecteur adjacent (26) de bord de carte, chaque boîtier (38 ou 68) de module de connecteur électrique contenant des bornes électriques (50 ou 70) frottant chacune contre un conducteur (58 ou 86) de cette partie, et étant chacun connectés directement, électriquement et mécaniquement à l'une, appropriée, des barres (10B' et 64) au moyen d'un tronçon de broche (54 ou 76) de la borne, qui a été ajusté à force dans un trou (56 ou 80) de la barre (10B' ou 64).

2. Ensemble selon la revendication 1, caractérisé en ce que les conducteurs omnibus (10B') de retour à la masse sont incorporés dans un châssis (10) de barres (10A, 10B et 10B') fixé contre une surface de la plaque (34) à circuit de base, les conducteurs omnibus (64) d'alimentation étant fixés à la surface opposée de la plaquette (34) à circuit de base, des bornes appropriées (70) des boîtiers (68) de modules de connecteurs électriques s'étendant à travers la plaquette (34) à circuit de base et pénétrant dans les conducteurs omnibus (64) d'alimentation.

3. Ensemble selon la revendication 2, caractérisé en ce que le châssis (10) se présente sous la forme d'une grille dont des barres extérieures (10A) sont fixées à une extrémité ouverte d'un bâti sous la forme d'une boîte métallique (2), les rainures de réception de cartes des connecteurs (26) de bords de cartes et les fentes (40 et 84) de réception de cartes des boîtiers (38 et 68) de connecteurs électriques s'ouvrant vers l'intérieur du bâti (2) qui présente des gorges internes destinées au guidage des cartes (14) dans les rainures des connecteurs (26) de bords de cartes et dans les fentes (40 et 84) des boîtiers (38 et 68) de modules de connecteurs électriques.

4. Ensemble selon la revendication 2 ou 3, caractérisé en ce que les conducteurs omnibus d'alimentation comprennent des paires de barres espacées et parallèles (64) s'étendant le long de bords extérieurs opposés du châssis (10).

5. Ensemble selon l'une quelconque des revendications précédentes, caractérisé en ce que chaque boîtier (38 ou 68) de module de connecteur comprend un élément isolant (44 ou 85) qui peut être engagé par un bord d'une carte (14) insérée dans la fente (40 ou 84) de réception de carte du boîtier (38 ou 68) pour retenir le bord de la carte (14) dans une position éloignée de la barre associée (10B' ou 64).

6. Ensemble selon l'une quelconque des revendications précédentes, caractérisé en ce que les tronçons de broche (54 et 76) des bornes comportent des sections (55 ou 76') qui sont fendues longitudinalement afin d'être flexibles dans la direction transversale des tronçons de broche (54 et 76), les sections fendues longitudinalement (55 ou 76') des tronçons de broche (54 ou 76) portant élastiquement contre les parois des trous (56 et 80) qui ont été percés dans les barres (10B' ou 64).

7. Ensemble selon l'une quelconque des revendications précédentes, caractérisé en ce que chaque boîtier (38 ou 68) de module de connecteur électrique est reçu dans une encoche (22 ou 24) de la carte (14) reçue dans la fente (40 ou 84) du boîtier (38 ou 68), chaque borne (50 ou 70) du boîtier (38 ou 68) de module comportant un tronçon de contact (51 ou 82) à ressort portant contre un plot métallique (58 ou 86) situé sur la carte (14), à la base de l'encoche (22 ou 24), chaque plot (58 ou 86) étant connecté, par l'intermédiaire de trous (62 ou 90) plaqués intérieurement et ménagés dans la carte (14), à un conducteur de circuit interne de la carte (14) et étant connecté directement à un conducteur (60 ou 88) de surface de la carte (14).

8. Ensemble selon l'une quelconque des revendications précédentes, caractérisé en ce que les boîtiers (38) de modules de connecteurs électriques, dont les bornes (50) sont connectées aux conducteurs omnibus (10B') de retour à la masse, comportent des parois latérales opposées (42) ayant chacune un voile (49) ajusté dans une gorge (53) d'une paroi extrême d'un connecteur adjacent (26) de bord de carte à circuit, les boîtiers (68) de connecteurs électriques, dont les bornes (70) sont connectées aux conducteurs omnibus d'alimentation, étant disposés de manière à être adjacents aux bords latéraux de la plaquette (34) à circuit de base et, par conséquent, extérieurement aux connecteurs (26) de bords de cartes à circuits.

**Patentansprüche**

1. Schaltungskarten-Verbindungsanordnung (1) mit einer Basis-Schaltungsplatte (34), einer Mehrzahl von elektrischen Kartenrand-verbindern (26), die an der Basis-Schaltungsplatte (34) angebracht sind und von denen jeder einen Aufnahmekanal für eine Karte (14) bildet, der mit Leitern der Basis-Schaltungsplatte (34) verbundene, an den Karten (14) angreifende Kontaktelemente enthält, wobei die Basis-Schaltungsplatte (34) mit Energieversorgungs-Sammelleitern (64) und Erdrückleitungs-Sammelleitern (10) versehen ist, die sich an dieser entlang erstrecken und mit den Schaltungen der Schaltungskarten (14) verbunden sind, die in den Kartenaufnahmekanälen der Kartenrandverbinder (26) aufgenommen sind, dadurch gekennzeichnet, daß die Sammelleiter in Form von beabstandeten Metall-Sammelschienen (64 und 10A, 10B') vorgesehen sind, die an der Basis-Schaltungsplatte (34) befestigt sind und sich von Ends zu Ende derselben erstrecken, daß die Kartenrandverbinder (26) zwischen den Erdrückleitungsschienen–(10A und 10B') positioniert sind, daß axial entlang der Schienen (64 und 10B') und darüber elektrische Erdrückleitungs-Verbindermodulgehäuse und Energieversorgungs-Verbindermodulgehäuse (38 und 68) verteilt sind, von denen jedes einen Kartenaufnahmeschlitz (40, 84) aufweist, der mit dem Kartenaufnahmeschlitz eines angrenzenden Schaltungskartenrandverbinders (26) ausgerichtet ist und einen Bereich einer Karte (14) aufnimmt, der auch in dem Karten-aufnahmekanal des angrenzenden Kartenrand-verbinders (26) aufgenommen ist, und daß jedes elektrische Verbindermodulgehäuse (38 oder 68) elektrische Anschlüsse (50 oder 70) enthält, von denen jeder an einem Leiter (58 oder 86) an einem solchen Bereich reibungsschlüssig angreift und von denen jeder elektrisch und mechanisch mit einer geeigneten der Schienen (10B' und 64) mittels eines Stiftbereichs des Anschlusses (54 oder 76) direkt verbunden ist, der in eine Öffnung (56 oder 80) in de Schiene (10B' oder 64) mit Preßsitz eingesetzt ist.

2. Anordnung nach Anspruch 1, dadurch gekennzeichnet, daß die Erdrückleitungs-Sammelleiter (10B') in einem Rahmengestell (10) aus Schienen (10A, 10B, 10B') enthalten sind, die an einer Oberfläche der Basis-Schaltungsplatte (34) befestigt sind, daß die Energieversorgungs-Sammelleiter (64) an der entgegengesetzten Oberfläche der Basis-Schaltungsplatte (34) befestigt sind, und daß sich geeignete Anschlüsse (70) der elektrischen Verbindermodulgehäuse (68) durch die Basis-Schaltungsplatte (34) hindurch in die Energie-Sammelleiter (64) erstrecken.

3. Anordnung nach Anspruch 2, dadurch gekennzeichnet, daß das Rahmengestell (10) die Form eines Gitters aufweist, wobei äußere Schienen (10A) desselben an einem offenen Ende eines Chassis in Form eines Metallkastens (2) befestigt sind, und daß die Kartenaufnahmekanäle der Kartenrandverbinder (26) und die Kartenaufnahmeschlitze (40 und 84) der elektrischen Verbindergehäuse (38 und 68) sich in das Innere des Chassis (2) öffnen, das mit inneren Nuten zur Führung der Karten (14) in die Kanäle der Kartenrandverbinder (26) und in die Schlitze (40 und 84) der elektrischen Verbindermodulgehäuse (38 und 68) versehen ist.

4. Anordnung nach Anspruch 2 oder 3, dadurch gekennzeichnet, daß die Energieversorgungs-Sammelleiter Paare von parallelen, beabstandeten Schienen (64) aufweisen, die sich entlang gegenüberliegenden äußeren Rändern des Rahmengestells (10) erstrecken.

5. Anordnung nach einem der vorausgehenden Ansprüche, dadurch gekennzeichnet, daß jedes Verbindermodulgehäuse (38 oder 68) ein Isolierelement (44 oder 85) aufweist, an dem eine Kante einer in den Kartenaufnahmeschlitz (40 oder 84) des Gehäuses (38 oder 68) eingesetzten Karte (14) angreift, um die Kante der Karte (14) in einer von der zugehörigen Schiene (10B' oder 64) entfernten Position zu halten.

6. Anordnung nach einem der vorausgehenden Ansprüche, dadurch gekennzeichnet, daß die Stiftbereiche (54 und 76) der Anschlüsse Abschnitte (55 oder 76') aufweisen, die längs geschlitzt sind, so daß diese in Querrichtung der Stiftbereiche (54 und 76) federnd nachgiebig sind, und daß die längs geschlitzten Abschnitte (55 oder 76') der Stiftbereiche (54 oder 76) an den Wänden der Öffnungen (56 oder 80), die in die Schienen (10B' oder 64) ge-bohrt sind, federnd angreifen.

7. Anordnung nach einem der vo-rausgehenden Ansprüche, dadurch gekenn-zeichnet, daß jedes elektrische Verbinder-modulgehäuse (38 oder 68) in einer Kerbe (22 oder 24) in der Karte (14) aufgenommen ist, die in dem Schlitz (40 oder 84) des Gehäuses (38 oder 68) aufgenommen ist, daß jeder Anschluß (50 oder 70) des Modulgehäuses (38 oder 68) einen Federkontaktbereich (51 oder 82) auf-weist, der an einer Metall-Kontaktierungsfläche (58 oder 86) auf der Karte (14) an der Basis der Kerbe (22 oder 24) angreift, und daß jede Kontaktierungsfläche (58 oder 86) mittels innen plattierter Löcher (62 oder 90) in der Karte (14) mit einer inneren Schaltungsbahn der Karte (14) verbunden ist und direkt mit einem Oberflächenleiter (60 oder 88) der Karte (14) verbunden ist.

8. Anordnung nach einem der vo-rausgehenden Ansprüche, dadurch gekenn-zeichnet, daß die elektrischen Verbinder-modulgehäuse (38), deren Anschlüsse (50) mit den Erdrückleitungs-Sammelleitern (10B') ver-bunden sind, gegenüberliegende Seitenwände (42) aufweisen, von denen jede einen Steg (49) aufweist, der in eine Nut (53) in einer Endwand eines angrenzenden Schaltungskartenrandverbinders (26) eingepaßt ist, und daß die elektrischen Verbindergehäuse (68), deren Anschlüsse (70) mit den Energieversorgungs-Sammelleitern verbunden sind, angrenzend an seitliche Kanten der Basis-Schaltungsplatte (34) und somit außerhalb der Schaltungs-kartenrandverbinder (26) angeordnet sind.

FIG.1.

FIG.2.

FIG.3.

FIG.4.

FIG.5.

FIG.6.

FIG.7.

FIG.8.